(19) Europäisches Patentamt
European Patent Office
Office européen des brevets

(11) **EP 4 345 371 A1**

(12) **EUROPEAN PATENT APPLICATION**

(43) Date of publication:
**03.04.2024 Bulletin 2024/14**

(21) Application number: **22198578.1**

(22) Date of filing: **29.09.2022**

(51) International Patent Classification (IPC):
**F21V 29/00** (2015.01)

(52) Cooperative Patent Classification (CPC):
**F21V 29/10; F21V 29/15; F21V 29/51;**
**F28D 15/025; H01L 33/648; H05K 7/20;**
H01L 23/427

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **Signify Holding B.V.**
**5656 AE Eindhoven (NL)**

(72) Inventor: **The designation of the inventor has not yet been filed**

(74) Representative: **Verweij, Petronella Daniëlle et al**
**Signify Netherlands B.V.**
**Intellectual Property**
**High Tech Campus 7**
**5656 AE Eindhoven (NL)**

(54) **LIGHTING SYSTEMS AND METHODS EMPLOYING THERMAL DIODES FOR HEAT MANAGEMENT**

(57)    Lighting systems employing droplet thermal diodes, and methods of their production, are disclosed. One lighting system (500) includes at least one light emitting diode (LED) (312), a driver (316) configured to power and drive the LED(s) and a droplet thermal diode (501). The diode (501) includes a smooth hydrophobic condenser (504), an evaporator (502) and a fluid medium (510) disposed between the condenser and the evaporator, where the condenser is spaced 1-500 μm from the evaporator and where the driver (316) and the LED(s) (312) are oppositely coupled to the thermal diode at opposing sides of the fluid medium (510).

FIG. 5

**Description**

TECHNICAL FIELD

The present invention is directed generally to heat management of lighting systems. More particularly, various inventive methods, systems and apparatus disclosed herein relate to lighting systems and methods utilizing thermal diodes.

BACKGROUND

Digital lighting technologies, i.e. illumination based on semiconductor light sources, such as light-emitting diodes (LEDs), offer a viable alternative to traditional fluorescent, HID, and incandescent lamps. Functional advantages and benefits of LEDs include high energy conversion and optical efficiency, durability, lower operating costs, and many others. Recent advances in light-emitting diode (LED) technology have provided efficient and robust full-spectrum lighting sources that enable a variety of lighting effects in many applications. Some of the fixtures embodying these sources feature a lighting module, including one or more LEDs capable of producing different colors, e.g. red, green, and blue, as well as a processor for independently controlling the output of the LEDs in order to generate a variety of colors and color-changing lighting effects.

Other components of a lighting fixture may include a driver, transformer, surge module and an illuminating circuit to perform different functions. The type and specification of these components depends on the environmental conditions, applications, and user experiences in which it is to be installed. As indicated above, there has been a major shift in technology in the last few decades from the use of traditional incandescent light sources to LED sources. This is mainly due to LEDs offering higher energy savings and lesser maintenance over their life span. The life span of LEDs largely depends on their operating temperature, where higher operating temperatures lower the life span of LEDs. With the advent of new technologies, the efficiency of LEDs has significantly increased, which in turn has decreased the total heat generation from the light source. Thus, thermal management of lighting fixtures is of great importance for the development of LED-based lighting systems. Typical methods for thermal management of electronic devices employ heat sinks, heat pipes, vapor chambers, absorption systems and/or thermal diodes.

Diodes are devices that conduct heat more efficiently in one direction, the forward mode, as compared to the other direction, the reverse mode. The effectiveness of the thermal diode is quantified by diodicity, denoted as $\eta$, which compares the effective conductivity in the forward mode, denoted as $k_f$, and the effective conductivity in the reverse mode, denoted as $k_r$, and is given by:

$$\eta = \left( k_f - k_r \right)/k_r \qquad\qquad (1)$$

Thermal diodes employed in current devices are typically solid-state or phase-change thermal diodes. Solid state devices are thermal property dependent devices with diodicity nearer to 1. In turn, phase change thermal diodes utilize latent heat of vaporization in the forward mode and thus have diodicity ranging from 10 to 100.

For example, thermosyphons are an example of phase change thermal diodes. Thermosyphons operate based on buoyant convection and are usually composed of vertically oriented hollow containers that are partially filled with liquid and transfer heat through the phase change of the liquid to the gaseous state. In turn, heat pipes utilize an evaporator section and a condenser having a wick structure, which condenses vapor and transfers the condensate to the evaporator section. Heat pipes have diodicity of -100. Further, jumping droplet thermal diodes utilize microscopic condensate that are propelled several millimeters into the air during coalescence events by a superhydrophobic nanostructure. The diodicity of jumping droplet thermal diodes is approximately -100.

SUMMARY

Lighting fixtures utilizing the above-described thermal management devices have major drawbacks. In particular, the thermal management devices are excessively direction dependent and/or have low reliability due to the materials used or to the fragility of the structures used. For example, the performance of thermosyphons strongly depends upon gravity and orientation due to their structure and reliance on buoyant convection. Heat pipes essentially provide a one-dimensional heat transfer that is ineffective in 3D systems. Although arrays of heat pipes can be used to alleviate this problem to some extent, their use adds additional complexity and size, and provides a cost in diodicity. In turn, the nanostructure of jumping thermal diodes is less durable and causes flooding after prolonged exposure.

Embodiments of the present application can address these problems by providing a lighting system with a thermal management device that is durable and capable of being used in a variety of orientations, and manages heat in a way that permits a compact structure. In particular, the heat management device permits coupling of an LED(s) on one side of the device and of other electronic components on the other side of the device such that heat is efficiently transferred to the ambient while at the same time ensuring that both the LED(s) and the electronic components are effectively shielded from each other. Specifically, the LED(s) are effectively shielded from heat generated by the electronic components at the other side of the thermal management device, and the electronic components are effectively shielded from heat generated by the LED(s).

One exemplary embodiment is directed to a lighting system including at least one LED, a driver configured to power and drive the LED(s) and a droplet thermal diode. The diode includes a smooth hydrophobic condenser, an evaporator and a fluid medium disposed between the condenser and the evaporator, where the condenser is spaced 1-500 μm from the evaporator and where the driver and the LED(s) are oppositely coupled to the thermal diode at opposing sides of the fluid medium.

In accordance with one exemplary aspect, the driver is coupled to the condenser and the LED(s) is coupled to the evaporator.

In accordance with another exemplary aspect, the evaporator comprises a microchannel wick structure drilled into a surface of the evaporator disposed in a chamber including the fluid medium.

In an additional exemplary aspect, the condenser comprises graphene or a grafted polymer on a surface of the condenser disposed in a chamber including the fluid medium. For example, the condenser can comprise a graphene monolayer on the surface of the condenser.

In accordance with an exemplary aspect, the total heat reaching the LED(s) from the driver is less than 5% of the total heat input to the thermal diode by the LED(s). Here, in one example, the total heat input into the thermal diode by the driver is primarily dissipated out of the thermal diode by the condenser.

Another exemplary embodiment is directed to a method for producing a lighting system employing a droplet thermal diode for heat management. The method includes preparing an evaporator of the thermal diode, preparing a smooth hydrophobic condenser of the thermal diode and conjoining the evaporator and the condenser with a fluid medium disposed between the condenser and the evaporator such that the condenser is spaced 1-500 μm from the evaporator. The method further includes coupling at least one LED to the thermal diode, and coupling a driver, configured to power and drive the LED(s), to the thermal diode such that the driver and the LED(s) are oppositely coupled to the thermal diode at opposing sides of the fluid medium.

In accordance with one exemplary aspect, the preparing the evaporator comprises drilling a microchannel wick structure into a surface of the evaporator. In another exemplary aspect, the preparing the smooth hydrophobic condenser comprises depositing a graphene or grafted polymer layer on a surface of the smooth hydrophobic condenser. For example, the preparing the smooth hydrophobic condenser can comprise depositing a graphene monolayer on the surface of the smooth hydrophobic condenser.

In accordance with another exemplary aspect, the conjoining comprises providing a gasket between the evaporator and the condenser to form a chamber between the evaporator and the condenser, and filling the chamber with the fluid medium. For example, the conjoining can comprise compressing the evaporator and the condenser so that the condenser is spaced 1-500 μm from the evaporator. In another exemplary aspect, the method comprises determining a liquid filler ratio based on heat load imposed by the LED(s), where the filling comprises filling the chamber with an amount of a liquid form of the fluid medium that is determined based on the determined liquid filler ratio.

In another exemplary aspect, the coupling the driver comprises coupling the driver to the condenser. In addition, the coupling the LED(s) comprises coupling the LED(s) to the evaporator.

As used herein for purposes of the present disclosure, the term "LED" should be understood to include any electroluminescent diode or other type of carrier injection/junction-based system that is capable of generating radiation in response to an electric signal. Thus, the term LED includes, but is not limited to, various semiconductor-based structures that emit light in response to current, light emitting polymers, organic light emitting diodes (OLEDs), electroluminescent strips, and the like. In particular, the term LED refers to light emitting diodes of all types (including semi-conductor and organic light emitting diodes) that may be configured to generate radiation in one or more of the infrared spectrum, ultraviolet spectrum, and various portions of the visible spectrum (generally including radiation wavelengths from approximately 400 nanometers to approximately 700 nanometers). Some examples of LEDs include, but are not limited to, various types of infrared LEDs, ultraviolet LEDs, red LEDs, blue LEDs, green LEDs, yellow LEDs, amber LEDs, orange LEDs, and white LEDs (discussed further below). It also should be appreciated that LEDs may be configured and/or controlled to generate radiation having various bandwidths (e.g., full widths at half maximum or FWHM) for a given spectrum (e.g., narrow bandwidth, broad bandwidth), and a variety of dominant wavelengths within a given general color categorization.

For example, one implementation of an LED configured to generate essentially white light (e.g., a white LED) may include a number of dies which respectively emit different spectra of electroluminescence that, in combination, mix to form essentially white light. In another implementation, a white light LED may be associated with a phosphor material that converts electroluminescence having a first spectrum to a different second spectrum. In one example of this implementation, electroluminescence having a relatively short wavelength and narrow bandwidth spectrum "pumps" the phosphor material, which in turn radiates longer wavelength radiation having a somewhat broader spectrum.

It should also be understood that the term LED does not limit the physical and/or electrical package type of an LED. For example, as discussed above, an LED may refer to a single light emitting device having multiple dies that are configured to respectively emit different spectra of radiation (e.g., that may or may not be individually controllable). Also, an LED may be associated with a phosphor that is considered as an integral part of the LED (e.g., some types of white LEDs). In general, the term LED may refer to packaged LEDs, non-packaged LEDs, surface mount LEDs, chip-on-board LEDs, T-package mount LEDs, radial package LEDs, power package LEDs, LEDs including some type of encasement and/or optical element (e.g., a diffusing lens), etc.

The term "light source" should be understood to refer to any one or more of a variety of radiation sources, including, but not limited to, LED-based sources (including one or more LEDs as defined above).

A given light source may be configured to generate electromagnetic radiation within the visible spectrum, outside the visible spectrum, or a combination of both. Hence, the terms "light" and "radiation" are used interchangeably herein. Additionally, a light source may include as an integral component one or more filters (e.g., color filters), lenses, or other optical components. Also, it should be understood that light sources may be configured for a variety of applications, including, but not limited to, indication, display, and/or illumination. An "illumination source" is a light source that is particularly configured to generate radiation having a sufficient intensity to effectively illuminate an interior or exterior space. In this context, "sufficient intensity" refers to sufficient radiant power in the visible spectrum generated in the space or environment (the unit "lumens" often is employed to represent the total light output from a light source in all directions, in terms of radiant power or "luminous flux") to provide ambient illumination (i.e., light that may be perceived indirectly and that may be, for example, reflected off of one or more of a variety of intervening surfaces before being perceived in whole or in part).

The term "spectrum" should be understood to refer to any one or more frequencies (or wavelengths) of radiation produced by one or more light sources. Accordingly, the term "spectrum" refers to frequencies (or wavelengths) not only in the visible range, but also frequencies (or wavelengths) in the infrared, ultraviolet, and other areas of the overall electromagnetic spectrum. Also, a given spectrum may have a relatively narrow bandwidth (e.g., a FWHM having essentially few frequency or wavelength components) or a relatively wide bandwidth (several frequency or wavelength components having various relative strengths). It should also be appreciated that a given spectrum may be the result of a mixing of two or more other spectra (e.g., mixing radiation respectively emitted from multiple light sources).

The term "lighting fixture" is used herein to refer to an implementation or arrangement of one or more lighting units in a particular form factor, assembly, or package. The term "lighting unit" is used herein to refer to an apparatus including one or more light sources of same or different types. A given lighting unit may have any one of a variety of mounting arrangements for the light source(s), enclosure/housing arrangements and shapes, and/or electrical and mechanical connection configurations. Additionally, a given lighting unit optionally may be associated with (e.g., include, be coupled to and/or packaged together with) various other components (e.g., control circuitry) relating to the operation of the light source(s). A lighting unit in accordance with embodiments of the present application can include an LED-based lighting unit and/or a multi-channel lighting unit. An "LED-based lighting unit" refers to a lighting unit that includes one or more LED-based light sources as discussed above, alone or in combination with other non LED-based light sources. A "multi-channel" lighting unit refers to an LED-based or non LED-based lighting unit that includes at least two light sources configured to respectively generate different spectrums of radiation, wherein each different source spectrum may be referred to as a "channel" of the multi-channel lighting unit.

The term "controller" is used herein generally to describe various apparatus relating to the operation of one or more light sources. A controller can be implemented in numerous ways (e.g., such as with dedicated hardware) to perform various functions discussed herein. A "processor" is one example of a controller which employs one or more microprocessors that may be programmed using software (e.g., microcode) to perform various functions discussed herein. A controller may be implemented with or without employing a processor, and also may be implemented as a combination of dedicated hardware to perform some functions and a processor (e.g., one or more programmed microprocessors and associated circuitry) to perform other functions. Examples of controller components that may be employed in various embodiments of the present disclosure include, but are not limited to, conventional microprocessors, application specific integrated circuits (ASICs), and field-programmable gate arrays (FPGAs).

In various implementations, a processor or controller may be associated with one or more storage media (generically referred to herein as "memory," e.g., volatile and non-volatile computer memory such as RAM, PROM, EPROM, and EEPROM, floppy disks, compact disks, optical disks, magnetic tape, etc.). In some implementations, the storage media may be encoded with one or more programs that, when executed on one or more processors and/or controllers, perform at least some of the functions discussed herein. Various storage media may be fixed within a processor or controller or may be transportable, such that the one or more programs stored thereon can be loaded into a processor or controller so as to implement various aspects of the present invention discussed herein. The terms "program" or "computer program" are used herein in a generic sense to refer to any type of computer code (e.g., software or microcode) that can be employed to program one or more processors or controllers.

The term "addressable" is used herein to refer to a device (e.g., a light source in general, a lighting unit or fixture, a controller or processor associated with one or more light sources or lighting units, other non-lighting related devices, etc.) that is configured to receive information (e.g., data) intended for multiple devices, including itself, and to selectively respond to particular information intended for it. The term "addressable" often is used in connection with a networked environment (or a "network," discussed further below), in which multiple devices are coupled together via some communications medium or media.

In one network implementation, one or more devices coupled to a network may serve as a controller for one or more other devices coupled to the network (e.g., in a master/slave relationship). In another implementation, a networked environment may include one or more dedicated controllers that are configured to control one or more of the devices coupled to the network. Generally, multiple devices coupled to the network each may have access to data that is present on the communications medium or media; however, a given device may be "addressable" in that it is configured to selectively exchange data with (i.e., receive data from and/or transmit data to) the network, based, for example, on one or more particular identifiers (e.g., "addresses") assigned to it.

The term "network" as used herein refers to any interconnection of two or more devices (including controllers or processors) that facilitates the transport of information (e.g. for device control, data storage, data exchange, etc.) between any two or more devices and/or among multiple devices coupled to the network. As should be readily appreciated, various implementations of networks suitable for interconnecting multiple devices may include any of a variety of network topologies and employ any of a variety of communication protocols. Additionally, in various networks according to the present disclosure, any one connection between two devices may represent a dedicated connection between the two systems, or alternatively a non-dedicated connection. In addition to carrying information intended for the two devices, such a non-dedicated connection may carry information not necessarily intended for either of the two devices (e.g., an open network connection). Furthermore, it should be readily appreciated that various networks of devices as discussed herein may employ one or more wireless, wire/cable, and/or fiber optic links to facilitate information transport throughout the network.

It should be appreciated that all combinations of the foregoing concepts and additional concepts discussed in greater detail below (provided such concepts are not mutually inconsistent) are contemplated as being part of the inventive subject matter disclosed herein. In particular, all combinations of claimed subject matter appearing at the end of this disclosure are contemplated as being part of the inventive subject matter disclosed herein. It should also be appreciated that terminology explicitly employed herein that also may appear in any disclosure incorporated by reference should be accorded a meaning most consistent with the particular concepts disclosed herein.

BRIEF DESCRIPTION OF THE DRAWINGS

In the drawings, like reference characters generally refer to the same parts throughout the different views. Also, the drawings are not necessarily to scale, emphasis instead generally being placed upon illustrating the principles of the invention.

FIG. 1 is a high-level diagram of a prior art lighting system.
FIG. 2 is a high-level diagram of a lighting system in accordance with exemplary embodiments of the present application.
FIG. 3 is a diagram of a lighting system in accordance with exemplary embodiments of the present application.
FIG. 4 is a diagram illustrating the operation of a droplet thermal diode.
FIG. 5 is a diagram of a lighting system in accordance with preferred exemplary embodiments of the present application.
FIG. 6 is a flow diagram of a method for producing a lighting system in accordance with exemplary embodiments of the present application.
FIG. 7-10 illustrate various stages of manufacturing of a lighting system in accordance with the method of FIG. 6.

DETAILED DESCRIPTION

Embodiments of the present application are directed to lighting systems and methods employing thermal diodes to manage heat within the systems. The lighting systems and thermal diodes employed therein are both durable and usable in a variety of orientations, and provide heat management in a way that enables a compact structure for the system. The heat management device permits coupling of one or more LEDs on one side of the device and of other electronic components on the other side of the device, and operates in such a way that heat is efficiently transferred to the ambient while at the same time ensuring that both the LED(s) and the electronic components are effectively shielded from heat generated at the other side of the thermal management device.

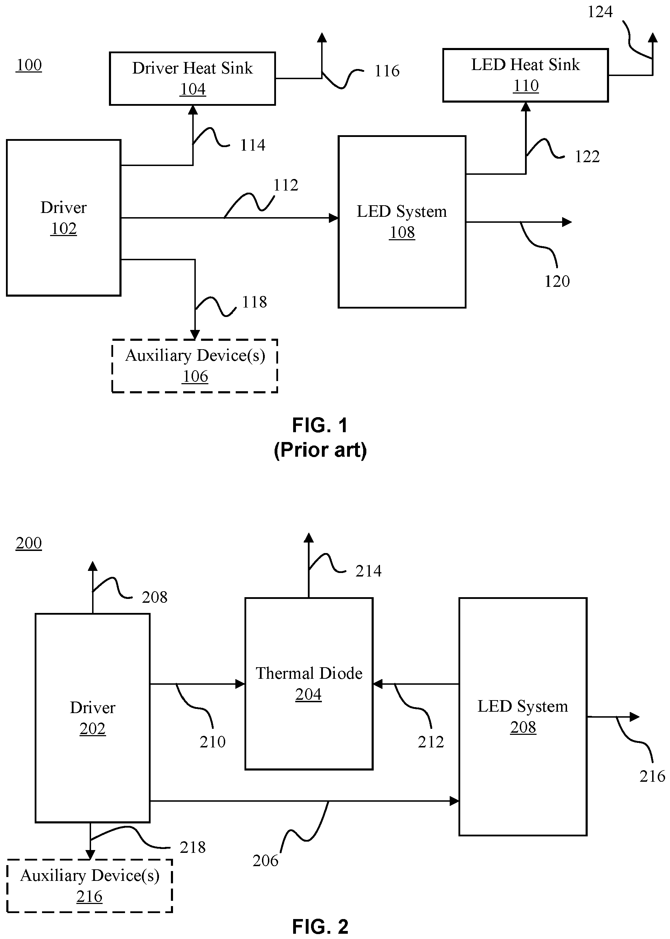

FIG. 1 illustrates the heat management design of existing lighting systems. As illustrated in FIG. 1, the lighting system 100 includes a driver 102, an LED system 108, a driver heat sink 104, an LED heat sink 110 and optional auxiliary device(s) 106. Here, the driver 102 provides power 112 to the LED System 108 and power 118 to any optional auxiliary devices 106. In addition, the driver 102 is also coupled to a driver heat sink 104 to which the driver 102 transfers heat 114, and the driver heat sink 104 in turn transfers heat 116 to the ambient. Further, the LED system 108 provides light output 120 and is coupled to a separate LED heat sink 110 to which the LED system 108 transfers heat 122, and the LED heat sink 110 transfers heat 124 to the ambient. Thus, the driver 102 here has its own heat sink 104 to transfer the heat 114 the driver 102 generates to the surrounding in order to maintain the temperature of the driver 102 below a threshold. The remaining power is used to drive the LEDs, which have their own thermal efficiency requirements. The heat 122 generated by the LEDs is then transferred to the surrounding using their own corresponding heat sink 110, and remaining power is then converted to light output 120. In the system 100, the driver 102 and the LEDs of the system 108 employ separate thermal management devices 104 and 110, as permitting the driver 102 and the LEDs of the system 108 to have thermal interaction with each other, e.g., when kept close together or otherwise, may negatively affect their operating temperatures. Thus, the system is large and bulky, which in turn increases packaging cost, weight, effective project area and cost of manufacture.

As indicated above, the effectiveness of the thermal management devices in existing lighting systems, such as, for example heat sinks, heat pipes, etc., are heavily direction dependent. However, it is desirable that lighting fixtures be used at various angles, such as downlight or sidelight or upward emitting light. Thus, employing a thermal management system that is independent of the direction of emission is an improvement over existing LED systems. Furthermore, given that the lighting system 100 of FIG. 1 is bulky and requires more space, area and material, a thermal management system that enables a more compact design for the lighting fixture is also an improvement and is desirable.

FIG. 2 illustrates a high-level diagram of a lighting system 200 in accordance with exemplary embodiments of the present application. As illustrated in FIG. 2, the lighting system 200 includes a driver 202, an LED system 208, a thermal diode 204 and optional auxiliary device(s) 216. Here, the driver provides power 210 to the LED System 208 and power 118 to any optional auxiliary devices 216. In accordance with the system 200, both the LED system 208 and the driver 202 are coupled to a thermal diode 204. Here, the structure of the thermal diode 204 is configured such that coupling of both the LEDs of the system 208 and the driver 202 to the thermal diode 204 enables efficient heat transfer from these components to the environment while at the same time sufficiently insulating the components from each other. As the driver 202 and the LEDs of the system 208 can be coupled to opposing sides of the same heat management device, the lighting system 200 can be designed to be more compact and use less space, area and material, thereby reducing packaging costs and orientation dependence.

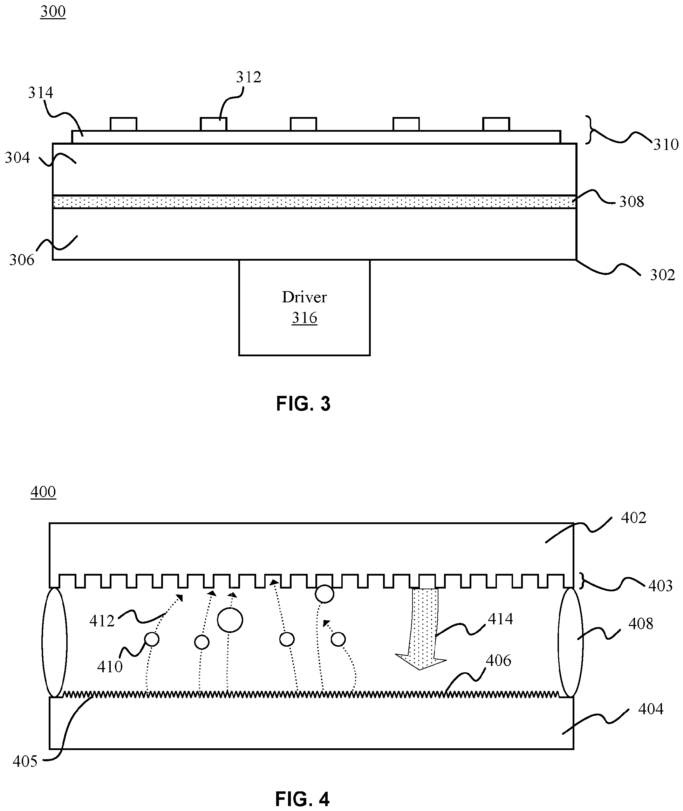

FIG. 3 depicts a high-level illustration of a lighting system 300 in accordance with an exemplary embodiment. The lighting system 300 includes an LED system 310 comprising a printed circuit board 314 and a plurality of LEDs 312, which generate heat. Here, the LED system 310 is coupled to an evaporator 304 of the thermal diode 302 and the driver 316 is coupled to the condenser 306 of the thermal diode 302, as the driver 316 typically generates less heat than the LEDs 310. The driver 316 is configured to power and drive the LEDs 312. The thermal diode 302 further comprises a chamber 308 including a fluid medium, whose operation is discussed in more detail herein below. Prior to discussing the thermal diodes employed by lighting systems of embodiments of the present application, a jumping droplet thermal diode 400 of FIG. 4 is described to better illustrate the operation of the thermal diodes employed by embodiments of the present application.

With reference to FIG. 4, a thermal diode 400 includes an evaporator 402, which comprises a wick structure 403, a seal 408 and a condenser 404, which comprises a coarse superhydrophobic nanostructure 405. Here, heat generated at the evaporator 402 converts liquid water droplets 410 into steam 414, which condenses back into liquid droplets 410 at the condenser 404 surface. In turn, the superhydrophobic nanostructure 405 causes the microscopic condensate 410 to jump several millimeters along paths 412 back towards the evaporator 402, and in this way heat is transferred from the evaporator 402 to the condenser 404. Here, the diodicity is on the order of -100, making the device highly direction dependent and effectively preventing the coupling of any electronic components directly to the condenser 404, due to the high risk of excessively increasing the operating temperature of such components. Furthermore, the thermal device 400 is also relatively large, as it utilizes a chamber between the evaporator 402 and the condenser 404 that is several millimeters wide.

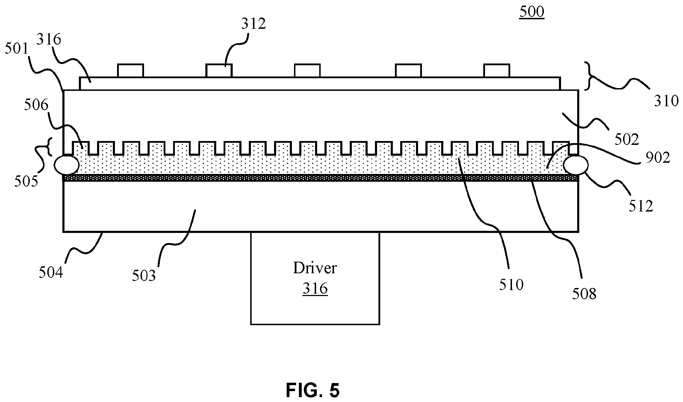

With reference now to FIG. 5, in contrast to lighting systems utilizing the jumping droplet thermal diode 400 of FIG. 4, a lighting system 500 in accordance with exemplary embodiments employs a droplet thermal diode 501 that is composed of a microscopic chamber 902, in which a fluid medium 510 is disposed, a smooth hydrophobic condenser 504 including a smooth hydrophobic layer 508 and a plate 503, and an evaporator 502, which includes a wick structure 505, which can be a microchannel wick structure. The chamber height 902 can be, for example, one to five hundred micrometers in accordance with exemplary embodiments, preferably between 200-400 micrometers, most preferable 200-300 micrometers. However, the size of the chamber can vary, for example, from 12mm to 25mm in height based on the lighting system that is being cooled by the diode. The lighting system 500 includes an LED system 310 comprising the printed circuit board 314 and a plurality of LEDs 312. Although a plurality of LEDs 312 are shown here, it should be understood that the LED system 310 can be composed of a single LED in alternative embodiments. As indicated above, the LED system 310 is coupled directly to an evaporator 502 of the thermal diode 501 and the driver 316 is coupled directly to the condenser 504 of the thermal diode 501. While the coupling here is direct, other couplings in which one or more heat conducting elements are disposed between the LED system 310 and the evaporator 502 and/or between the driver 316 and the condenser 504 can be employed. The lighting system 500 includes a seal 512 forming a chamber 902 between the evaporator 502 and the condenser 504. The chamber 902 comprises a fluid medium 510 that includes a mix of gaseous and liquid phases. In preferred embodiments, the fluid medium is water, but suitable other mediums can be employed. As illustrated in FIG. 5, the wick structure 505 of the evaporator 502 and the surface of the hydrophobic layer 508 are disposed in the chamber 902. Here, the thermal diode operates in a manner similar to the droplet thermal diode discussed above. In particular, liquid droplets of the medium 510 are heated in the wick structure 505, composed of channels 506, of the evaporator 502, which induces a phase change into gas that is diffused to the hydrophobic layer 508 of the condenser 504. At or near the condenser 504, the gaseous medium condenses into liquid droplets that are propelled by the hydrophobic layer 508 towards the wick structure 505, repeating the process and enabling heat transfer to the evaporator 504 and out of the diode 501 to the ambient. As discussed below, the structure is such that the evaporator 504 acts as a heat spreader effectively insulating and protecting the driver 316 from heat produced by the LEDs 310 and also effectively insulating and protecting the LEDs from heat produced by the driver 316. The smooth hydrophobic condenser 504 permits the use of a thin microscopic chamber 902, which in turn reduces the size of the thermal diode 501, enabling a more compact lighting system design. Moreover, the use of the smooth hydrophobic condenser provides more strength and durability as opposed to the superhydrophobic nanostructure of the jumping thermal droplet diode 400, which is more fragile. Further, the thermal properties of the diode 501, due in part to the smooth hydrophobic condenser 504, enables the coupling of the LED system 310 and the driver 316 to opposing sides of the same diode 501, thereby further permitting an even more compact design. Here, the LED(s) 312 are effectively shielded from heat generated by the driver 316 at the other side of the thermal diode 501, and the driver 316 is effectively shielded from heat generated by the LED(s) 312. Thus, in accordance with exemplary embodiments, as illustrated in FIG. 5, the driver 316 and the LED(s) 312 are oppositely coupled to the thermal diode 501 at opposing sides of the fluid medium 510. It should be noted that other electronic components in addition to or as an alternative to the driver 316 can be coupled to the condenser 504 for thermal management purposes.

In accordance with a preferred embodiment, the bridging-droplet thermal diode 501 includes two opposing copper plates as the evaporator 502 and condenser 504, with the evaporator 502 having a wick structure 505, while the condenser 504 is smooth and hydrophobic, separated by an insulating and water-resistant gasket 512. After sealing the chamber, water, used as the fluid medium 510, is injected into the wick structure 505 and non-condensable gases are removed. Two plates of copper are used with the dimensions of that of the light square. Microchannels 506 are drilled into the plate, where the height, pitch and thickness of the channels can be altered based on the volume fraction needed. The two plates 502/504 are then pressed with gaskets between leaving a micrometer gap. In the forward mode of operation, the heat source is located on the back face of the wicked copper plate 502 and, here, is the LED system 310. Steam carries the latent heat across the gap through the chamber 902 and is transferred to the hydrophobic plate by dropwise condensation. The moderately large contact angles of the dew droplets enable them to bridge the gap and to wick back into the opposing evaporator for sustained phase-change heat transfer. In the reverse, the heat source is now located on the back face of the smooth hydrophobic plate 504, which is in this example attached the driver 316, resulting in dry-out and poor heat transfer across the vapor space 902 from the driver 316. A hydrophobic layer 508 is deposited on a surface of the plate 503 of the condenser 504 with for example, a graphene coating, a grafted polymer coating or a coating composed of other suitable material. Thus, the LED system 310 will heat up the copper plate of the evaporator 502, which results in water of the medium 510 heating up and being converted into steam. Similarly, the driver 316 on the condenser side also heats up the diode 501, but the heat does not reach the LED side due to higher diodicity of the thermal diode and is purely conducted to the copper plate of the condenser 504 which acts as the heat spreader. Thus, in accordance with exemplary embodiments, the total heat input into the thermal diode 501 by the driver 316 is primarily dissipated out of the thermal diode 501 by the condenser 504.

As an example, consider a light square (1Lsq) used for providing the specific lumen output as per a given application. The span of the 1Lsq can be, for example, around $130 \times 130$mm. Heat generation through the light square for providing the lumen output of 4000 lumen is around 50W. Two copper blocks of span $150 \times 150$mm are used as the evaporator and condenser as discussed above. Microchannel arrays 506 are drilled into the evaporator section with thickness, height and length of channels as a function of the volume fraction needed for the given heat transfer. For the present case, solid volume fraction is maintained to be $\phi=0.25$. The thickness of each cooper block is maintained at 6 mm. For making the condenser sections, in accordance with one embodiment, a hydrophobic graphene monolayer is coated as the layer 508 on the surface of the copper plate composing the condenser 504. The two copper plates are then compressed against each other with gasket 512 between them to prevent any water leakage. The chamber 902 is sealed against gaskets which leave around ~250$\mu$m as the vapor space between the outer edge of the wick structure 505 and the layer 508. The overall heat transfer co-efficient in the forward mode is governed by 1) Conduction resistance across the wick 505, 2) the interfacial resistance across the evaporating interface, and 3) the overall thermal resistance of dropwise condensate. In particular, the heat transfer coefficient ($h_f$) in the forward mode is given by:

$$\frac{1}{h_f} = \frac{H_w}{k_w} + \frac{1}{h_e} + \frac{1}{h_c} \qquad (2)$$

where $H_w$ is the height of the wick structure 505, $k_w$ is the conductivity of the wick structure, $h_e$ is the heat transfer coefficient of the evaporator 502 and $h_c$ is the heat transfer coefficient of the condenser 504.

The heat transfer coefficient $h_f$ increases from 4 to 38 kW/m$^2$K when average temperature is increased from 25°C to 83°C. For a lighting application example, limiting the LED temperature to 90°C, for example, and an ambient temperature of 40°C, the average temperature is 65°C, so that the heat transfer coefficient $h_f$ with variation in average temperature, $h_f$ @Tavg=65°C, is 12 kW/m$^2$K. The maximum heat load that can be embedded in the given area is calculated as follows:

$$h_f = \frac{Q}{A_{eff}\Delta T} \qquad (3)$$

where Q is the heat load, $A_{eff}$ is the effective area, which is = 50 cm$^2$ for the example described above, and $\Delta T$ is the temperature difference between the evaporator and the condenser.

Applying equation (3) using these values results in Q being approximately 3000W, which is the heat that can be safely generated by the LED system. However, using factors of safety of ten, for example, for the present lighting system example which accounts for the losses due to imperfect contacts, water leakages, etc., Q of approximately 300W can be used for an exemplary practical lighting application. Thus, the traditional 4000 lumen or 50W light square can be replaced by 24000 lumen or 300W system in the same area. The droplet thermal diode 501 in accordance with an exemplary embodiment has higher diodicity of approximately 40 at an average temperature of 65°C. This means that only 3% of the total heat generated in the forward mode is generated in the reverse mode. Thus, in accordance with exemplary embodiments, the total heat reaching the LED(s) 312 from the driver 316 is less than 5% of total heat input to the thermal diode 501 by the LED(s) 312. This ensures that there is effectively thermal isolation between both of the heat generating components, e.g. LED system 310 and the driver 316, which in turn minimizes the thermal interaction of the driver and the LEDs.

Thus, due to the configuration of the lighting system and the heat management system used, the packaging size, weight, effective projected area, which is important for vibration, and cost can be reduced as compared with present lighting systems. Moreover, the lumen output can be increased by further reducing any leakages and contact resistances.

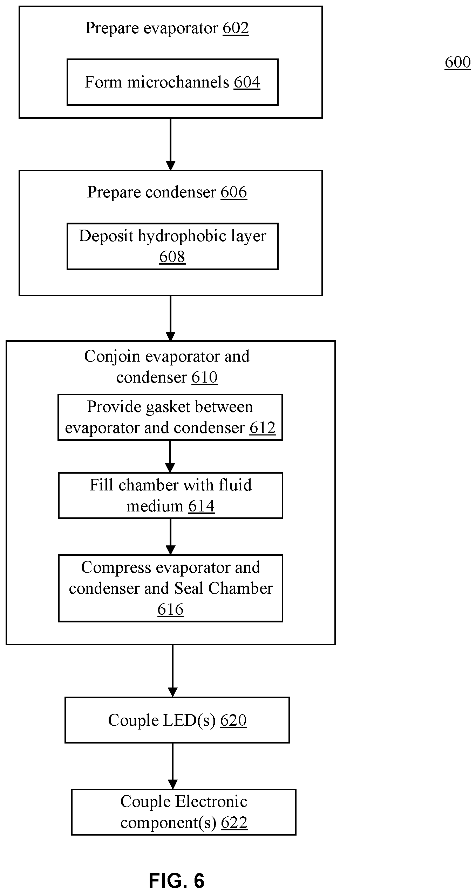

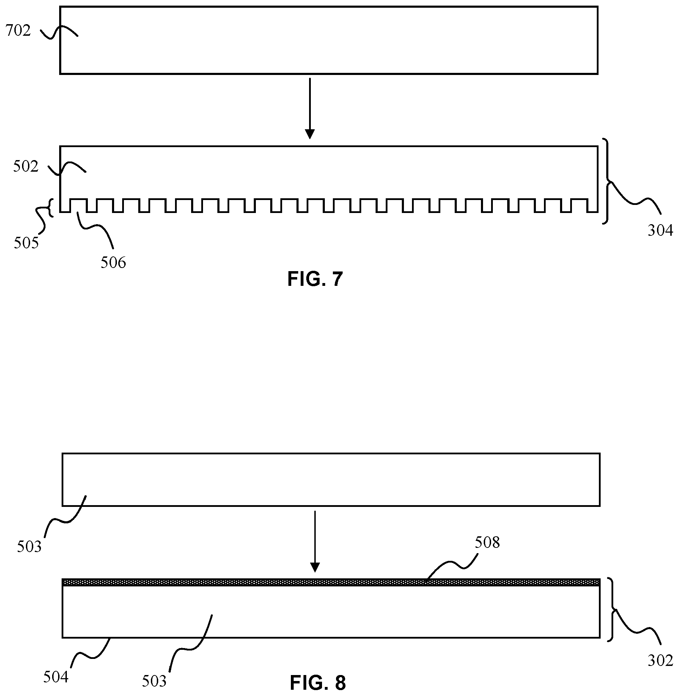

Referring now to FIG. 6, with continuing reference to FIG. 5, a method 600 for producing a lighting system 500 is illustratively depicted. At step 602, an evaporator 502 of the thermal diode 501 is prepared. For example, as illustrated in FIG. 7, a heat conducting plate 702 is provided. The plate 702 can be, for example, a metal, preferably copper. However, any suitable heat conducting plate can be employed. In accordance with one exemplary embodiment, the evaporator height can vary, for example, from 5mm to 10mm in height. In addition, at step 604, an array of interconnected microchannels 506 is formed, e.g., drilled, into the plate throughout the surface of the plate to form the wick structure 505 of the evaporator 502, as shown in FIG. 7. In accordance with exemplary embodiments, the dimensions of the micropillar/channels 506 can vary based on the heat load of the light engine of the LED system 310. For example, the size of a channel 506 can vary from anything between 100μm to 500μm according to the filler ratio needed or used. It should be understood that the evaporator 502 is an15 implementation of the evaporator 304 illustrated in FIG. 3.

At step 606, a condenser 504 of the thermal diode 501 is prepared. For example, as illustrated in FIG. 8, a heat conducting plate 503 is provided. The plate 503 can be, for example, a metal, preferably copper. However, any suitable heat conducting plate can be employed. In accordance with an exemplary embodiment, the condenser height can vary from, for example, 5mm to 10mm in height. As illustrated in FIG. 8, at step 608, a hydrophobic layer 508 is deposited on the plate 503. As noted above, the hydrophobic layer 508 can be, for example, graphene or a grafted polymer. For example, the hydrophobic layer 508 can be a graphene monolayer. However, any suitable hydrophobic layer can be employed. It should be understood that the condenser 504 is an implementation of the condenser 302 illustrated in FIG. 3.

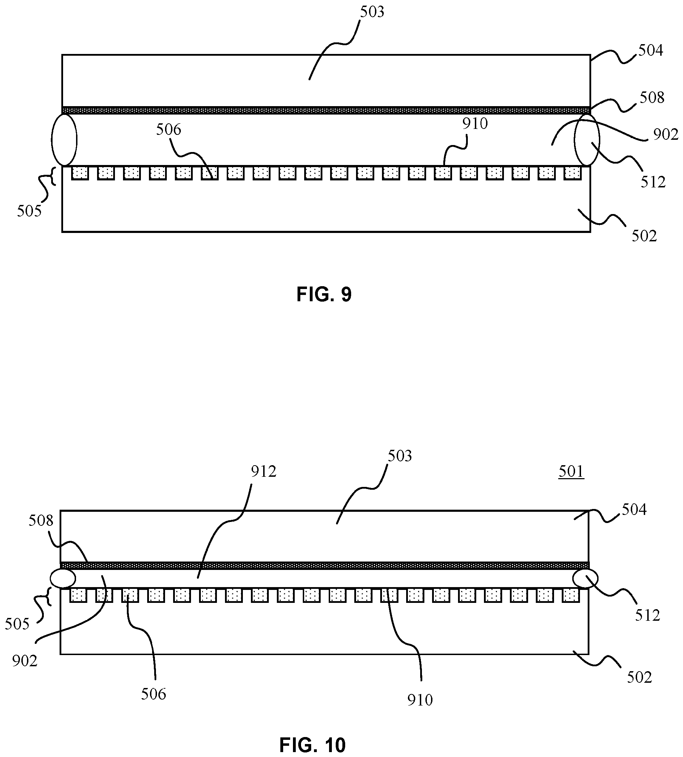

At step 610, the evaporator 502 and the condenser 504 are conjoined. For example, as illustrated in FIG. 9, at step 612, a gasket 512, is provided between the condenser 504 and the evaporator 502. In accordance with a preferred embodiment, the gasket 512 is an O-ring. At step 614, the chamber 902 is at least partially filled with a fluid medium 910, and any non-condensable gases are removed. For example, the medium 910 can be water, and the chamber 902 can be injected with water to fill the microchannel structure 506, where the gasket 512 is an16 insulating water-resistant gasket. However, it should be understood than any suitable liquid medium can be employed. Further, as discussed above, during operation, the fluid medium 510 can be composed of liquid 910 and a gaseous form of the liquid 910. For example, the medium 510 can be composed of both water and water vapor during operation of the lighting system 500 when heat is generated by the LEDs 312 of the LED system 310 and/or other components coupled to the thermal diode 501, such as, for example, the driver 316.

At step 616, the evaporator 502 and the condenser 504 can be compressed and the chamber 902 can be sealed, as illustrated in FIG. 10. Preferably, the evaporator and the condenser are compressed so that the condenser is spaced 1-500 $\mu$m from the evaporator. For example, in accordance with exemplary embodiments, the condenser is spaced 200-400 $\mu$m from the evaporator, e.g. 250 $\mu$m.

At step 620, the LED system 310 is coupled to the droplet thermal diode 501, and at step 622, one or more electronic components can be coupled to the thermal diode 501 to form the lighting system 500 of FIG. 5. For example, the LED system 310 can be coupled to the evaporator 502 at step 620, while one or more electronic components can be coupled to the condenser 504 of thermal diode 501 at step 622. For example, the driver 316 can be coupled to the condenser 504. However, it should be understood that any electronic component of the lighting system can be coupled to the condenser 504. Preferably, the LED system 310 and the electronic component(s) are directly coupled, for example, by mechanical means, such as a screw or clip, to the evaporator 502 and condenser 504, respectively. While the coupling here is direct, other couplings in which one or more heat conducting elements are disposed between the LED system 310 and the evaporator 502 and/or between the electronic component(s) and the condenser 504 can be employed. For example, heat conductive glue can be used to couple the LED system 310 to the evaporator and/or to couple the electronic component(s) and the condenser 504. Alternatively, heat conductive wires or tracers can be used to couple the LED system 310 to the evaporator and/or to couple the electronic component(s) and the condenser 504.

It should also be understood the diode 501 can be adapted to various heat loads by altering the filler ratio at step 614. In particular, the heat transfer capability of the diode 501 can be scaled to handle various heat loads input into the diode 501 by the LEDs 312 and/or by the electronic component(s), in this case a driver 316, on the opposing side of the diode 501. For example, based on the behavior of the heat sources 312 and/or 316, an empirical correlation can be determined for the specific application between liquid filler ratio and the heat load imposed by the heat sources 312 and/or 316. Thus, optionally, at step 614, a liquid filler ratio can be empirically determined through repetition with various amounts of liquid filler and corresponding observation of the heat loads imposed by the heat sources 312 and/or 316 at each iteration. Accordingly, at step 614, the final amount of liquid medium 910 placed on the evaporator during filling can be tailored to the determined ratio, which in turn is empirically determined based on the heat load in the system 500 imposed by the heat sources 312 and/or 316.

While several inventive embodiments have been described and illustrated herein, those of ordinary skill in the art will readily envision a variety of other means and/or structures for performing the function and/or obtaining the results and/or one or more of the advantages described herein, and each of such variations and/or modifications is deemed to be within the scope of the inventive embodiments described herein. More generally, those skilled in the art will readily appreciate that all parameters, dimensions, materials, and configurations described herein are meant to be exemplary and that the actual parameters, dimensions, materials, and/or configurations will depend upon the specific application or applications for which the inventive teachings is/are used. Those skilled in the art will recognize, or be able to ascertain using no more than routine experimentation, many equivalents to the specific inventive embodiments described herein. It is, therefore, to be understood that the foregoing embodiments are presented by way of example only and that, within the scope of the appended claims and equivalents thereto, inventive embodiments may be practiced otherwise than as specifically described and claimed. Inventive embodiments of the present disclosure are directed to each individual feature, system, article, material, kit, and/or method described herein. In addition, any combination of two or more such features, systems, articles, materials, kits, and/or methods, if such features, systems, articles, materials, kits, and/or methods are not mutually inconsistent, is included within the inventive scope of the present disclosure.

All definitions, as defined and used herein, should be understood to control over dictionary definitions, definitions in documents incorporated by reference, and/or ordinary meanings of the defined terms.

The indefinite articles "a" and "an," as used herein in the specification and in the claims, unless clearly indicated to the contrary, should be understood to mean "at least one."

The phrase "and/or," as used herein in the specification and in the claims, should be understood to mean "either or both" of the elements so conjoined, i.e., elements that are conjunctively present in some cases and disjunctively present in other cases. Multiple elements listed with "and/or" should be construed in the same fashion, i.e., "one or more" of the elements so conjoined. Other elements may optionally be present other than the elements specifically identified by the "and/or" clause, whether related or unrelated to those elements specifically identified. Thus, as a non-limiting example, a reference to "A and/or B", when used in conjunction with open-ended language such as "comprising" can refer, in one embodiment, to A only (optionally including elements other than B); in another embodiment, to B only (optionally including elements other than A); in yet another embodiment, to both A and B (optionally including other elements); etc.

As used herein in the specification and in the claims, "or" should be understood to have the same meaning as "and/or" as defined above. For example, when separating items in a list, "or" or "and/or" shall be interpreted as being inclusive, i.e., the inclusion of at least one, but also including more than one, of a number or list of elements, and, optionally, additional unlisted items. Only terms clearly indicated to the contrary, such as "only one of' or "exactly one of," or, when used in the claims, "consisting of," will refer to the inclusion of exactly one element of a number or list of elements. In general, the term "or" as used herein shall only be interpreted as indicating exclusive alternatives (i.e. "one or the other but not both") when preceded by terms of exclusivity, such as "either," "one of," "only one of," or "exactly one of." "Consisting essentially of," when used in the claims, shall have its ordinary meaning as used in the field of patent law.

As used herein in the specification and in the claims, the phrase "at least one," in reference to a list of one or more elements, should be understood to mean at least one element selected from any one or more of the elements in the list of elements, but not necessarily including at least one of each and every element specifically listed within the list of elements and not excluding any combinations of elements in the list of elements. This definition also allows that elements may optionally be present other than the elements specifically identified within the list of elements to which the phrase "at least one" refers, whether related or unrelated to those elements specifically identified. Thus, as a non-limiting example, "at least one of A and B" (or, equivalently, "at least one of A or B," or, equivalently "at least one of A and/or B") can refer, in one embodiment, to at least one, optionally including more than one, A, with no B present (and optionally including elements other than B); in another embodiment, to at least one, optionally including more than one, B, with no A present (and optionally including elements other than A); in yet another embodiment, to at least one, optionally including more than one, A, and at least one, optionally including more than one, B (and optionally including other elements); etc.

It should also be understood that, unless clearly indicated to the contrary, in any methods claimed herein that include more than one step or act, the order of the steps or acts of the method is not necessarily limited to the order in which the steps or acts of the method are recited.

In the claims, as well as in the specification above, all transitional phrases such as "comprising," "including," "carrying," "having," "containing," "involving," "holding," "composed of," and the like are to be understood to be open-ended, i.e., to mean including but not limited to. Only the transitional phrases "consisting of' and "consisting essentially of' shall be closed or semi-closed transitional phrases, respectively, as set forth in the United States Patent Office Manual of Patent Examining Procedures, Section 2111.03.

## Claims

1.   A lighting system (500) comprising:

    at least one light emitting diode (LED) (312);
    a driver (316) configured to power and drive said at least one LED; and
    a droplet thermal diode (501) including a smooth hydrophobic condenser (504), an evaporator (502) and a fluid medium (510) disposed between the condenser and the evaporator, wherein the condenser is spaced 1-500 μm from the evaporator and wherein the driver and the at least one LED are oppositely coupled to said thermal diode at opposing sides of said fluid medium.

2.   The lighting system of claim 1, wherein the driver (316) is coupled to said condenser (504) and wherein the at least one LED (312) is coupled to said evaporator (502).

3.   The lighting system of claim 1, wherein the evaporator (502) comprises a microchannel wick structure (505) drilled into a surface of the evaporator disposed in a chamber (902) including said fluid medium (510).

4.   The lighting system of claim 1, wherein the condenser (504) comprises graphene or a grafted polymer (508) on a surface of the condenser disposed in a chamber including said fluid medium.

5.   The lighting system of claim 4, wherein the condenser (504) comprises said graphene on said surface of the condenser, and wherein the graphene is a graphene monolayer.

6.   The lighting system of claim 1, wherein total heat reaching the at least one LED from the driver is less than 5% of total heat input to the thermal diode by the at least one LED.

7. The lighting system of claim 6, wherein total heat input into the thermal diode by the driver is primarily dissipated out of the thermal diode by the condenser.

8. A method (600) for producing a lighting system employing a droplet thermal diode for heat management comprising:

preparing (602) an evaporator of said thermal diode;
preparing (606) a smooth hydrophobic condenser of said thermal diode;
conjoining (610) said evaporator and said condenser with a fluid medium disposed between the condenser and the evaporator such that the condenser is spaced 1-500 $\mu$m from the evaporator;
coupling (620) at least one light emitting diode (LED) to said thermal diode; and
coupling (622) a driver, configured to power and drive said at least one LED, to said thermal diode such that the driver and the at least one LED are oppositely coupled to said thermal diode at opposing sides of said fluid medium.

9. The method of claim 8, wherein the preparing (602) the evaporator comprises drilling (604) a microchannel wick structure into a surface of the evaporator.

10. The method of claim 8, wherein the preparing (606) the smooth hydrophobic condenser comprises depositing (608) a graphene or grafted polymer layer on a surface of the smooth hydrophobic condenser.

11. The method of claim 8, wherein the preparing (606) the smooth hydrophobic condenser comprises depositing (608) a graphene monolayer on the surface of the smooth hydrophobic condenser.

12. The method of claim 8, wherein the conjoining (610) comprises providing (612) a gasket between the evaporator and the condenser to form a chamber between the evaporator and the condenser and filling (614) the chamber with the fluid medium.

13. The method of claim 12, wherein the conjoining (610) comprises compressing (616) the evaporator and the condenser so that the condenser is spaced 1-500 $\mu$m from the evaporator.

14. The method of claim 12, further comprising determining a liquid filler ratio based on heat load imposed by at least said at least one LED, wherein said filling comprises filling the chamber with an amount of a liquid form of said medium that is determined based on said determined liquid filler ratio.

15. The method of claim 8, wherein the coupling (622) the driver comprises coupling the driver to the condenser.

FIG. 1
(Prior art)

FIG. 2

300

314    312

304    308

306    302

310

Driver
316

**FIG. 3**

400    402

403

412    414
408
410    406

404

405

**FIG. 4**

**FIG. 5**

600

Prepare evaporator 602

Form microchannels 604

Prepare condenser 606

Deposit hydrophobic layer 608

Conjoin evaporator and condenser 610

Provide gasket between evaporator and condenser 612

Fill chamber with fluid medium 614

Compress evaporator and condenser and Seal Chamber 616

Couple LED(s) 620

Couple Electronic component(s) 622

**FIG. 6**

702

502

505

506

304

**FIG. 7**

503

508

504

503

302

**FIG. 8**

503

504

508

910

506

902

512

505

502

**FIG. 9**

912

503

501

508

504

505

902

506

910

512

502

**FIG. 10**

Europäisches
Patentamt

European
Patent Office

Office européen
des brevets

## EUROPEAN SEARCH REPORT

Application Number

EP 22 19 8578

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | KR 101 439 954 B1 (IL KWANG LIGHTING CO LTD [KR]) 4 November 2014 (2014-11-04) * figures 1,3 * | 1-15 | INV. F21V29/00 |
| Y | EDALATPOUR MOJTABA ET AL: "Bridging-Droplet Thermal Diodes", ADVANCED FUNCTIONAL MATERIALS, vol. 30, no. 43, 18 August 2020 (2020-08-18), page 2004451, XP055903212, DE ISSN: 1616-301X, DOI: 10.1002/adfm.202004451 Retrieved from the Internet: URL:https://onlinelibrary.wiley.com/doi/full-xml/10.1002/adfm.202004451> * the whole document * | 1-15 | |
| Y | WO 2021/263114 A2 (VIRGINIA POLYTECHNIC INSTITUTE AND STATE UNIV [US]) 30 December 2021 (2021-12-30) * the whole document * | 1-15 | |

TECHNICAL FIELDS SEARCHED (IPC)

F28F
F25D
F21V
F28D

The present search report has been drawn up for all claims

| Place of search | Date of completion of the search | Examiner |
|---|---|---|
| The Hague | 17 March 2023 | Kebemou, Augustin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.............................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 22 19 8578**

This annex lists the patent family members relating to the patent documents cited in the above-mentioned European search report.
The members are as contained in the European Patent Office EDP file on
The European Patent Office is in no way liable for these particulars which are merely given for the purpose of information.

**17-03-2023**

| Patent document cited in search report | Publication date | Patent family member(s) | Publication date |
|---|---|---|---|
| KR 101439954 B1 | 04-11-2014 | NONE | |
| WO 2021263114 A2 | 30-12-2021 | NONE | |

EPO FORM P0459

For more details about this annex : see Official Journal of the European Patent Office, No. 12/82